# EUROPÄISCHE PATENTANMELDUNG

(11) **EP 4 290 572 A1**
(43) Veröffentlichungstag der Anmeldung: **13.12.2023**
(21) Anmeldenummer: 22177837.6
(22) Anmeldetag: 08.06.2022
(51) Int. Cl.: H01L 23/485, H01L 23/49

(54) **HALBLEITERANORDNUNG MIT EINEM SCHALTBAREN HALBLEITERELEMENT**

(71) Anmelder: Siemens Aktiengesellschaft, 80333 München (DE)
(72) Erfinder: Kürten, Bernd, 90587 Obermichelbach (DE); Schmenger, Jens, 91301 Forchheim (DE)
(74) Vertreter: Siemens Patent Attorneys

(57) **Zusammenfassung**

Die Erfindung betrifft eine Halbleiteranordnung (2) mit einem schaltbaren Halbleiterelement (4), welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist, wobei die Steuerkontakt-Kontaktfläche (12) und die Lastkontakt-Kontaktfläche (14) bündig auf einer Halbleiteroberfläche (16) abschließend angeordnet sind. Um eine einfache und günstigere Kontaktierung zu ermöglichen, wird vorgeschlagen, dass ein metallisches Kontaktierungselement (22) flächig mit der Steuerkontakt-Kontaktfläche (12) des Steuerkontakts (6) verbunden ist (28), wobei das metallische Kontaktierungselement (22) eine auf einer der Steuerkontakt-Kontaktfläche (12) abgewandten Seite angeordnete Kontaktierungselement-Kontaktfläche (24) aufweist, welche größer als die Steuerkontakt-Kontaktfläche (12) ist, wobei das metallische Kontaktierungselement (22) die Lastkontakt-Kontaktfläche (14) des Lastkontakts (8) teilweise überlappt, wobei zwischen dem metallischen Kontaktierungselement (22) und der Lastkontakt-Kontaktfläche (14) des Lastkontakts (8) eine elektrisch isolierende Schicht (26) angeordnet ist.

## Beschreibung

Die Erfindung betrifft eine Halbleiteranordnung mit einem schaltbaren Halbleiterelement.

### Ferner betrifft die Erfindung einen Stromrichter mit mindestens einer derartigen Halbleiteranordnung

Darüber hinaus betrifft die Erfindung ein Verfahren zur Herstellung einer Halbleiteranordnung mit einem schaltbaren Halbleiterelement.

Eine derartige Halbleitermodulanordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die in der Halbleitermodulanordnung zum Einsatz kommenden schaltbaren Halbleiterelemente sind beispielsweise Transistoren, Triacs oder Thyristoren. Die Transistoren sind beispielsweise als Insulated-Gate-Bipolar-Transistoren (IGBTs), Feldeffekttransistoren oder Bipolartransistoren ausgeführt. Derartige Transistoren weisen üblicherweise einen Steueranschluss und Lastanschlüsse mit jeweils einem Kontaktierungsbereich, beispielsweise ein Kontakt-Pad, auf, wobei der Kontaktierungsbereich eines Lastanschlusses in der Regel eine größere Fläche aufweist als der Kontaktierungsbereich eines Steueranschlusses, da die Fläche für den Kontaktierungsbereich des Steueranschlusses mit der aktiven Chipfläche konkurriert. Desto mehr aktive Chipfläche das schaltbare Halbleiterelement aufweist, desto mehr Strom kann bei gleicher Temperatur im Vergleich zu einer geringeren aktiven Chipfläche geschaltet werden. Wird die Fläche für den Kontaktierungsbereich des Steueranschlusses größer ausgeführt, wird die aktive Chipfläche verkleinert.

Daher werden üblicherweise Bondverbindungsmittel, z.B. Bonddrähte, einer geringeren Stärke zur Kontaktierung von Steueranschlüssen verwendet als zur Kontaktierung von Lastanschlüssen. Daher sind bei der Herstellung zumindest zwei Bondautomaten erforderlich, welche zur Kontaktierung in zumindest zwei Prozessschritten herangezogen werden, was zu längeren Prozesszeiten bei der Modulherstellung führt. Darüber hinaus steigen die Herstellungskosten aufgrund der Anschaffung und Wartung des zweiten Bondautomaten. Zudem benötigt der zweite Bondautomat Stellfläche in einer kostenintensiven Reinraumumgebung, was die Modulherstellung zusätzlich verteuert.

Vor diesem Hintergrund ist es eine Aufgabe der vorliegenden Erfindung, eine Halbleiteranordnung mit einem schaltbaren Halbleiterelement anzugeben, welche einfacher und günstiger kontaktierbar ist.

Diese Aufgabe wird erfindungsgemäß gelöst durch eine Halbleiteranordnung mit einem schaltbaren Halbleiterelement, welches zumindest ein Steuerkontakt mit einer Steuerkontakt-Kontaktfläche und zumindest einen Lastkontakt mit einer Lastkontakt-Kontaktfläche, welche größer als die Steuerkontakt-Kontaktfläche ist, aufweist, wobei die Steuerkontakt-Kontaktfläche und die Lastkontakt-Kontaktfläche bündig auf einer Halbleiteroberfläche abschließend angeordnet sind, wobei ein metallisches Kontaktierungselement flächig mit der Steuerkontakt-Kontaktfläche des Steuerkontakts verbunden ist, wobei das metallische Kontaktierungselement eine auf einer der Steuerkontakt-Kontaktfläche abgewandten Seite angeordnete Kontaktierungselement-Kontaktfläche aufweist, welche größer als die Steuerkontakt-Kontaktfläche ist, wobei das metallische Kontaktierungselement die Lastkontakt-Kontaktfläche des Lastkontakts teilweise überlappt, wobei zwischen dem metallischen Kontaktierungselement und der Lastkontakt-Kontaktfläche des Lastkontakts eine elektrisch isolierende Schicht angeordnet ist.

Ferner wird die Aufgabe erfindungsgemäß gelöst durch einen Stromrichter mit mindestens einer derartigen Halbleiteranordnung.

Darüber hinaus wird die Aufgabe erfindungsgemäß gelöst durch ein Verfahren zur Herstellung einer Halbleiteranordnung mit einem schaltbaren Halbleiterelement, welches zumindest ein Steuerkontakt mit einer Steuerkontakt-Kontaktfläche und zumindest einen Lastkontakt mit einer Lastkontakt-Kontaktfläche, welche größer als die Steuerkontakt-Kontaktfläche ist, aufweist, wobei die Steuerkontakt-Kontaktfläche und die Lastkontakt-Kontaktfläche bündig auf einer Halbleiteroberfläche abschließend angeordnet sind, wobei ein metallisches Kontaktierungselement mit einer Kontaktierungselement-Kontaktfläche, welche größer als die Steuerkontakt-Kontaktfläche ist, bereitgestellt wird, wobei das metallische Kontaktierungselement auf einer der Kontaktierungselement-Kontaktfläche abgewandten Seite derartig flächig mit der Steuerkontakt-Kontaktfläche des Steuerkontakts verbunden wird, dass das metallische Kontaktierungselement die Lastkontakt-Kontaktfläche des Lastkontakts teilweise überlappt, wobei zwischen dem metallischen Kontaktierungselement und der Lastkontakt-Kontaktfläche des Lastkontakts eine elektrisch isolierende Schicht angeordnet wird.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde, eine Kontaktfläche zur Kontaktierung eines Steuerkontakts eines schaltbaren Halbleiterelements zu vergrößern, ohne die aktive Chipfläche des schaltbaren Halbleiterelements zu verringern. Ein derartiges schaltbares Halbleiterelement weist zumindest ein Steuerkontakt mit einer Steuerkontakt-Kontaktfläche und zumindest einen Lastkontakt mit einer Lastkontakt-Kontaktfläche auf, wobei die Lastkontakt-Kontaktfläche größer als die Steuerkontakt-Kontaktfläche ist. Beispielsweise kann eine Größe der Lastkontakt-Kontaktfläche im Quadratmillimeterbereich liegen, während eine Größe der Steuerkontakt-Kontaktfläche im Quadratmikrometerbereich liegen. Das schaltbare Halbleiterelement kann unter anderem als ein vertikales Halbleiterelement, insbesondere als ein Insulated-Gate-Bipolar-Transistor (IGBT), ausgeführt sein. Ein derartiger IGBT weist als Steuerkontakt einen Gate-Kontakt und als Lastkontakte einen Emitter-Kontakt und einen Kollektor-Kontakt auf, wobei die Lastkontakte eines vertikalen Halbleiterelements auf gegenüberliegenden Seiten angeordnet sind. Weitere Beispiele für derartige schaltbare Halbleiterelemente sind Triacs, Thyristoren oder andere Transistortypen wie Feldeffekttransistoren und Bipolartransistoren. Der Steuerkontakt und der Lastkontakt kann ein, insbesondere rechteckiges, metallisches Kontakt-Pad umfassen, welches zur Verbindung zumindest eines Bondverbindungsmittels konfiguriert ist. Die Steuerkontakt-Kontaktfläche und die Lastkontakt-Kontaktfläche sind bündig auf einer Halbleiteroberfläche abschließend angeordnet, sodass diese über Bondverbindungsmittel kontaktierbar sind. Bondverbindungsmittel können unter anderem Bonddrähte oder Bondbänder sein, welche beispielsweise mittels eines Schweißverfahrens, insbesondere eines Reibschweiß-Verfahrens, stoffschlüssig mit den Kontaktflächen verbindbar sind.

Ein metallisches Kontaktierungselement wird flächig mit der Steuerkontakt-Kontaktfläche des Steuerkontakts verbunden, wobei die flächige Verbindung unter anderem stoffschlüssig ausgeführt sein kann. Das metallische Kontaktierungselement kann Aluminium, Silber, Gold, Kupfer, Zink oder eine deren Legierungen enthalten. Ferner weist das metallische Kontaktierungselement auf einer der Steuerkontakt-Kontaktfläche abgewandten Seite eine Kontaktierungselement-Kontaktfläche auf, welche größer als die Steuerkontakt-Kontaktfläche ist, sodass das metallische Kontaktierungselement die Lastkontakt-Kontaktfläche des Lastkontakts teilweise überlappt. Zwischen dem metallischen Kontaktierungselement und der Lastkontakt-Kontaktfläche des Lastkontakts ist eine elektrisch isolierende Schicht angeordnet. Die elektrisch isolierende Schicht ist beispielsweise aus einem dielektrischen Werkstoff hergestellt. Der dielektrische Werkstoff kann unter anderem einen keramischen Werkstoff wie Aluminiumoxid und/oder einem glasartigen Werkstoff, der insbesondere Siliciumdioxid oder ein Silicat enthält, aufweisen. Die elektrisch isolierende Schicht, welche beispielsweise eine Dicke von 0,5 µm bis 10 µm aufweist, kann auf dem metallischen Kontaktierungselement oder auf der Lastkontakt-Kontaktfläche angeordnet sein. Durch eine derartige elektrisch isolierende Schicht wird unter anderem die mechanische Stabilität der Anordnung verbessert und ein möglicher Kurzschluss verhindert. Durch die im Vergleich zur Steuerkontakt-Kontaktfläche größere Kontaktierungselement-Kontaktfläche des metallischen Kontaktierungselements wird die Verwendung von Bondverbindungsmitteln mit dickerem Leiterquerschnitt ermöglicht. Beispielsweise sind Bonddrähte mit einer Leiterdicke von mindestens 300 µm, insbesondere mindestens 500 µm, verwendbar. Insbesondere wird durch das metallische Kontaktierungselement eine Bondverbindung mit denselben Bondverbindungsmitteln für den Steuerkontakt und den Lastkontakt ermöglicht, ohne die aktive Chipfläche des schaltbaren Halbleiterelements zu verringern, sodass der Herstellungsprozess des Leistungsmoduls einfacher und schneller ablaufen kann. Ferner werden unter anderem zusätzliche Rüstzeiten eingespart, sodass durch die Zeitersparnis Herstellungskosten verringert werden.

Eine weitere Ausführungsform sieht vor, dass die Kontaktierungselement-Kontaktfläche mindestens vier Mal, insbesondere mindestens acht Mal, so groß wie die Steuerkontakt-Kontaktfläche ist. Beispielsweise liegt eine Fläche für ein Kontaktpad zwischen 120 µm x 300 µm für 100 µm Bonddrahtstärke und 350 µm x 1000 µm für 300 µm Bonddrahtstärke. Durch eine derartige Größe sind dickere Bondverbindungsmittel zuverlässig verbindbar.

Eine weitere Ausführungsform sieht vor, dass das metallische Kontaktierungselement stoffschlüssig mit Steuerkontakt-Kontaktfläche verbunden ist. Unter anderem ist eine stoffschlüssige Verbindung durch Adhäsion, Löten, Sintern oder mittels eines additiven Verfahrens herstellbar. Während des Betriebes des schaltbaren Halbleiterelements können im Bereich der Steuerkontakt-Kontaktfläche vergleichsweise hohe Temperaturen, beispielsweise im Bereich von 200°C bis 300°C sowie Temperaturschwankungen auftreten. Eine derartige stoffschlüssige Verbindung ist, insbesondere bei derartig hohen Temperaturen und Temperaturschwankungen zuverlässig.

Eine weitere Ausführungsform sieht vor, dass das metallische Kontaktierungselement zumindest teilweise mittels eines lithographischen, insbesondere photolithographischen, Verfahrens aufgebracht ist. Bei einem derartigen lithographischen Verfahren wird ein metallischer Werkstoff des metallischen Kontaktierungselements unter Einsatz zumindest einer Maske, insbesondere einer Photomaske bzw. Photolackmaske, auf die Steuerkontakt-Kontaktfläche aufgebracht. Das Aufbringen kann unter anderem durch Abscheiden, insbesondere durch Sputtern und/oder Aufdampfen, erfolgen. Durch ein derartiges Verfahren zeichnet sich dadurch aus, dass sehr feine Strukturen realisiert werden können.

Eine weitere Ausführungsform sieht vor, dass das metallische Kontaktierungselement über eine Sinterverbindung mit der Steuerkontakt-Kontaktfläche verbunden ist. Beispielsweise ist das metallische Kontaktierungselement als ein Blech, insbesondere als ein Kupferblech, ausgeführt, welches über eine Sinterverbindung mit der Steuerkontakt-Kontaktfläche verbunden ist. Eine derartige Sinterverbindung ist zuverlässig und ermöglicht eine hohe Lebensdauer der Halbleiteranordnung.

Eine weitere Ausführungsform sieht vor, dass die elektrisch isolierende Schicht stoffschlüssig mit der Lastkontakt-Kontaktfläche verbunden ist. Beispielsweise wird die elektrisch isolierende Schicht auf die Lastkontakt-Kontaktfläche durch Adhäsion, Sintern oder durch Aufsprühen aufgebracht. Auf diese Weise sind sehr dünne Schichten realisierbar.

Eine weitere Ausführungsform sieht vor, dass das metallische Kontaktierungselement flächig auf der elektrisch isolierenden Schicht aufliegt. Durch eine derartige flächige Kontaktierung wird die mechanische Stabilität der Anordnung verbessert.

Eine weitere Ausführungsform sieht vor, dass die elektrisch isolierende Schicht mittels eines lithographischen, insbesondere photolithographischen, Verfahrens auf die Lastkontakt-Kontaktfläche aufgebracht ist. Bei einem derartigen lithographischen Verfahren wird ein dielektrischer Werkstoff der elektrisch isolierenden Schicht unter Einsatz zumindest einer Maske, insbesondere einer Photomaske bzw. Photolackmaske, auf die Steuerkontakt-Kontaktfläche aufgebracht. Das Aufbringen kann unter anderem durch Abscheiden, insbesondere durch Sputtern und/oder Aufdampfen, erfolgen. Durch ein derartiges Verfahren zeichnet sich dadurch aus, dass sehr feine Strukturen realisiert werden können.

Eine weitere Ausführungsform sieht vor, dass die elektrisch isolierende Schicht zumindest teilweise durch Oxidieren des metallische Kontaktierungselements hergestellt ist. Beispielsweise wird das metallische Kontaktierungselement in einem Überlappungsbereich mit der Lastkontakt-Kontaktfläche mit Aluminium beschichtet, wobei die Aluminiumschicht in einem darauffolgenden Schritt zumindest teilweise gezielt und kontrolliert zu Aluminiumoxid oxidiert wird. Eine gezielte und kontrollierte Oxidation findet unter definierten Rahmenbedingungen wie z.B. Atmosphäre, Temperatur, Zeit statt. Durch Oxidation sind sehr dünne Schichten realisierbar.

Eine weitere Ausführungsform sieht vor, dass die Lastkontakt-Kontaktfläche über zumindest ein erstes Bondverbindungsmittel und die Kontaktierungselement-Kontaktfläche über ein zweites Bondverbindungsmittel mit einem Substrat verbunden ist, wobei eine Leitergeometrie des zumindest einen ersten Bondverbindungsmittels mit einer Leitergeometrie des zweiten Bondverbindungsmittels übereinstimmt. Unter einer identischen Leitergeometrie ist in diesem Zusammenhang eine identische Leiterquerschnittsfläche und eine identische Leiterquerschnittsform zu verstehen. Somit wird durch das metallische Kontaktierungselement eine Bondverbindung mit denselben Bondverbindungsmitteln für den Steuerkontakt und den Lastkontakt ermöglicht, sodass der Herstellungsprozess einfacher und schneller ablaufen kann.

Eine weitere Ausführungsform sieht vor, dass die Lastkontakt-Kontaktfläche und die Kontaktierungselement-Kontaktfläche in einem Prozesschritt über Bondverbindungsmittel mit einem Substrat verbunden werden. Unter einer Verbindung in einem Prozesschritt ist in diesem Zusammenhang zu verstehen, dass die Kontaktierung der Lastkontakt-Kontaktfläche und der Kontaktierungselement-Kontaktfläche mit Hilfe einer einzigen Maschine und/oder von derselben Spule erfolgt. Auf diese Weise wird der Herstellungsprozess vereinfacht und es werden Kosten eingespart.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Halbleiteranordnung in einer Querschnittsdarstellung,
- FIG 2: eine schematische Darstellung einer zweiten Ausführungsform einer Halbleiteranordnung in einer Querschnittsdarstellung,
- FIG 3: eine schematische Darstellung einer dritten Ausführungsform einer Halbleiteranordnung in einer Draufsicht,
- FIG 4: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

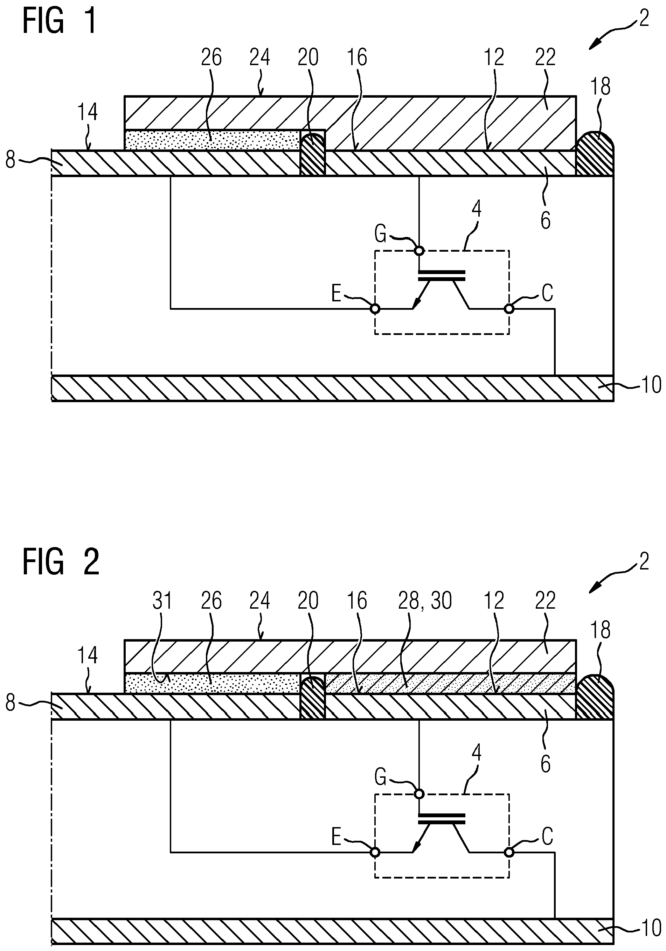

FIG 1 zeigt eine schematische Darstellung einer ersten Ausführungsform einer Halbleiteranordnung 2 in einer Querschnittsdarstellung, welche ein, insbesondere vertikales, schaltbares Halbleiterelement 4 aufweist. Beispielhaft ist das schaltbare Halbleiterelement 4 als ein Insulated-Gate-Bipolar-Transistor (IGBT) ausgeführt. Weitere Beispiele für schaltbare Halbleiterelemente 4 sind Triacs, Thyristoren oder andere Transistortypen wie Feldeffekttransistoren und Bipolartransistoren. Das schaltbare Halbleiterelement 4 umfasst einen Gate-Anschluss G, einen Kollektor-Anschluss C und einen Emitter-Anschluss E. Der Gate-Anschluss G ist chipintern mit einem Steuerkontakt 6, welcher als Gate-Kontakt ausgeführt ist, verbunden, während der Emitter-Anschluss E chipintern mit einem Lastkontakt 8, welcher als Emitter-Kontakt ausgeführt ist, verbunden ist. Auf einer dem Steuerkontakt 6 und dem Lastkontakt 8 gegenüberliegenden Seite der Halbleiteranordnung 2 ist ein weiterer Lastkontakt 10 angeordnet, welcher chipintern mit dem Kollektor-Anschluss C des vertikalen Halbleiterelements 4 verbunden und als Kollektor-Kontakt ausgeführt ist. Da es sich in FIG 1 beispielhaft um einen vertikalen Halbleiter handelt, sind Lastkontakte 8, 10 auf gegenüberliegenden Seiten angeordnet.

Der Steuerkontakt 6 und die Lastkontakte 8, 10 umfassen jeweils ein, insbesondere rechteckiges, metallisches Kontakt-Pad, welches zur Verbindung zumindest eines Bondverbindungsmittels konfiguriert ist. Ein derartiges Bondverbindungsmittel kann unter anderem ein Bonddraht und/oder ein Bondband sein. Ferner weisen der Steuerkontakt 6 eine Steuerkontakt-Kontaktfläche 12 und der Lastkontakt 8 eine Lastkontakt-Kontaktfläche 14 auf, wobei die Steuerkontakt-Kontaktfläche 12 wesentlich kleiner als die Lastkontakt-Kontaktfläche 14 ist. Die Steuerkontakt-Kontaktfläche 12 und die Lastkontakt-Kontaktfläche 14 sind bündig auf einer Halbleiteroberfläche 16 abschließend angeordnet.

Der Steuerkontakt 6 grenzt an einen elektrisch isolierenden Schutzring 18, welcher beispielhaft die Halbleiteroberfläche 16 und somit die Steuerkontakt-Kontaktfläche 12 und die Lastkontakt-Kontaktfläche 14 überragt. Fener ist zwischen dem Steuerkontakt 6 und dem Lastkontakt 8 eine elektrisch isolierende Zwischenschicht 20 angeordnet, welche beispielhaft die Halbleiteroberfläche 16 ebenfalls überragt. Beispielsweise weisen der elektrisch isolierenden Schutzring 18 und die elektrisch isolierende Zwischenschicht 20 einen dielektrischen Werkstoff, insbesondere Polyimid, auf.

Ein metallisches Kontaktierungselement 22 ist flächig mit der Steuerkontakt-Kontaktfläche 12 des Steuerkontakts 6 verbunden, wobei das metallische Kontaktierungselement 22 eine auf einer der Steuerkontakt-Kontaktfläche 12 abgewandten Seite angeordnete Kontaktierungselement-Kontaktfläche 24 aufweist, welche größer als die Steuerkontakt-Kontaktfläche 12 ist und somit beispielsweise zur Kontaktierung von Bondverbindungsmitteln mit einem größeren Durchmesser konfiguriert ist. Beispielsweise ist die Kontaktierungselement-Kontaktfläche 24 zumindest vier Mal, insbesondere zumindest acht Mal, so groß wie die Steuerkontakt-Kontaktfläche 12. Das metallische Kontaktierungselement 22 ist aus zumindest einem metallischen Werkstoff hergestellt. Zumindest im Bereich der Kontaktierungselement-Kontaktfläche 24 enthält das metallische Kontaktierungselement 22 Aluminium, Silber, Gold, Kupfer, Zink oder eine deren Legierungen.

Darüber hinaus überlappt das metallische Kontaktierungselement 22 die Lastkontakt-Kontaktfläche 14 des Lastkontakts 8 teilweise, wobei im Bereich der Überlappung zwischen dem metallischen Kontaktierungselement 22 und der Lastkontakt-Kontaktfläche 14 des Lastkontakts 8 eine elektrisch isolierende Schicht 26 angeordnet ist. Die elektrisch isolierende Schicht 26 ist aus einem dielektrischen Werkstoff hergestellt. Der dielektrische Werkstoff kann unter anderem einen keramischen Werkstoff wie Aluminiumoxid und/oder einem glasartigen Werkstoff, der insbesondere Siliciumdioxid oder ein Silicat enthält, aufweisen.

Das metallische Kontaktierungselement 22 ist stoffschlüssig mit Steuerkontakt-Kontaktfläche 12 verbunden. In FIG 1 ist das metallische Kontaktierungselement 22 mittels eines lithographischen, insbesondere photolithographischen, Verfahrens aufgebracht. Bei dem lithographischen Verfahren wird der zumindest eine metallische Werkstoff des metallischen Kontaktierungselements 22 unter Einsatz zumindest einer Maske, insbesondere einer Photomaske bzw. Photolackmaske, auf die Steuerkontakt-Kontaktfläche 12 aufgebracht. Das Aufbringen kann unter anderem durch Abscheiden, insbesondere durch Sputtern und/oder Aufdampfen, erfolgen. Nach dem Abscheiden kann eine, insbesondere galvanische, Verstärkung des metallischen Kontaktierungselements 22 erfolgen. Alternativ kann das metallische Kontaktierungselement 22 mittels eines additiven Verfahrens, insbesondere mittels eines thermischen Spritzverfahrens wie Kaltgasspritzen, aufgebracht werden.

Die elektrisch isolierende Schicht 26 ist darüber hinaus stoffschlüssig mit der Lastkontakt-Kontaktfläche 14 verbunden. In FIG 1 ist die elektrisch isolierende Schicht 26 mittels eines lithographischen, insbesondere photolithographischen, Verfahrens auf die Lastkontakt-Kontaktfläche 14 aufgebracht. Das Aufbringen kann unter anderem durch Abscheiden, insbesondere durch Sputtern und/oder Aufdampfen, erfolgen. Alternativ kann die elektrisch isolierende Schicht 26 adhäsiv oder additiv, insbesondere mittels eines thermischen Spritzverfahrens, aufgebracht werden. Das metallische Kontaktierungselement 22 ist flächig mit der elektrisch isolierenden Schicht 26 kontaktiert. Überdies kann das metallische Kontaktierungselement 22 flächig mit der elektrisch isolierenden Schicht 26 kontaktiert sein.

FIG 2 zeigt eine schematische Darstellung einer zweiten Ausführungsform einer Halbleiteranordnung 2 in einer Querschnittsdarstellung. Das metallische Kontaktierungselement 22 ist beispielhaft als Blech, insbesondere als Kupferblech, ausgeführt. Ferner kann das Blech eine einseitige und/oder beidseitige Beschichtung, beispielsweise zur Herstellung einer Bondverbindung, aufweisen. Eine derartige Beschichtung kann unter anderem Aluminium, Silber, Gold, Zink oder eine deren Legierungen enthalten. Das in FIG 2 als Blech ausgeführte metallische Kontaktierungselement 22 ist über eine stoffschlüssige Verbindung 28, welche beispielhaft eine Sinterverbindung 30 umfasst, mit der Steuerkontakt-Kontaktfläche 12 verbunden. Beispielsweise wird ein Sintermaterial, welches beispielsweise sinterfähiges Silber enthält, auf ein Kupferblech aufgebracht, das vor dem Aufbringen des Sintermaterials zumindest im Bereich der Sinterverbindung mit Silber oder Nickel-Gold beschichtet wurde.

Darüber hinaus liegt das metallische Kontaktierungselement 22 flächig auf der elektrisch isolierenden Schicht 26 auf. Die elektrisch isolierende Schicht 26 ist aus einem dielektrischen Werkstoff hergestellt. Der dielektrische Werkstoff kann unter anderem einen keramischen Werkstoff wie Aluminiumoxid und/oder einem glasartigen Werkstoff, der insbesondere Siliciumdioxid oder ein Silicat enthält, aufweisen. Zusätzlich oder alternativ kann die elektrisch isolierende Schicht 26 zumindest teilweise durch Oxidieren des metallische Kontaktierungselements 22 hergestellt sein. Beispielsweise wird das metallische Kontaktierungselement 22 in einem Überlappungsbereich 31 mit der Lastkontakt-Kontaktfläche 14 mit Aluminium beschichtet, wobei die Aluminiumschicht in einem darauffolgenden Schritt zumindest teilweise gezielt und kontrolliert zu Aluminiumoxid oxidiert wird. Eine gezielte und kontrollierte Oxidation findet unter definierten Rahmenbedingungen wie z.B. Atmosphäre, Temperatur, Zeit statt. Die weitere Ausgestaltung der Halbleiteranordnung 2 in FIG 2 entspricht der in FIG 1.

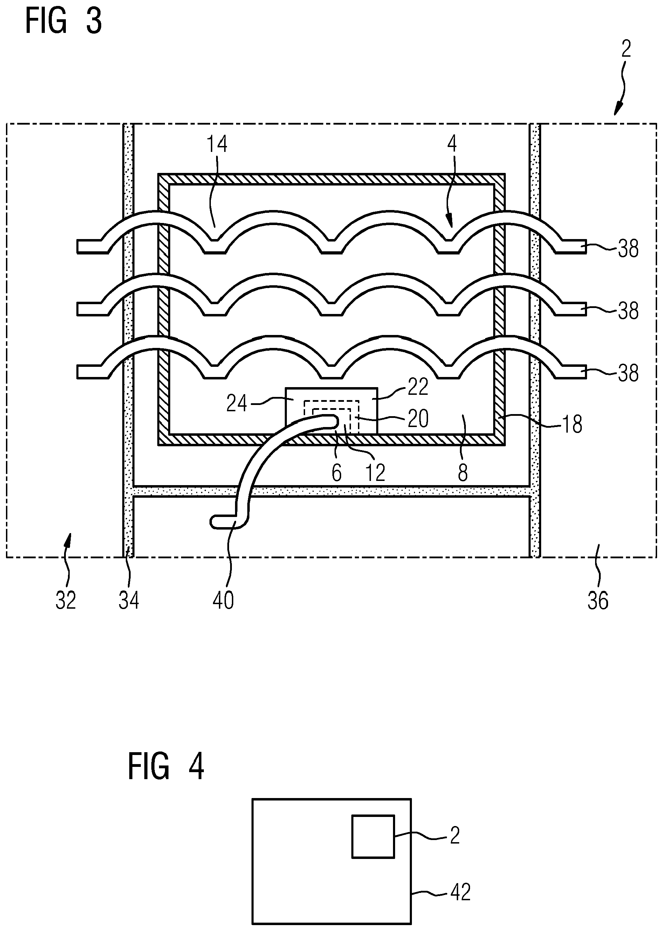

FIG 3 zeigt eine schematische Darstellung einer dritten Ausführungsform einer Halbleiteranordnung 2 in einer Draufsicht, wobei das als IGBT ausgeführte Halbleiterelement 4 über den weiteren Leistungskontakt 10 stoffschlüssig mit einem Substrat 32 verbunden ist. Das Halbleiterelement 4 weist eine Seitenlänge im Bereich von 5 mm bis 10 mm auf, während die Steuerkontakt-Kontaktfläche 12 eine Seitenlänge im Bereich von 0,5 mm bis 1,5 mm aufweist. Das Substrat 32 umfasst eine dielektrische Materiallage 34 sowie eine strukturierte Metallisierung 36. Das metallische Kontaktierungselement 22 kann wie in FIG 1 oder in FIG 2 dargestellt ausgeführt sein. Die Lastkontakt-Kontaktfläche 14 ist über beispielhaft drei erste Bondverbindungsmittel 38 mit der strukturierten Metallisierung 36 des Substrats 32 verbunden, während die Kontaktierungselement-Kontaktfläche 24 über ein zweites Bondverbindungsmittel 40 mit der strukturierten Metallisierung 36 des Substrats 32 verbunden ist. Die Bondverbindungsmittel 38, 40 sind beispielhaft als Bonddrähte ausgeführt. Alternativ könne die Bondverbindungsmittel 38, 40 unter anderem als Bondbänder ausgeführt sein.

Die Bondverbindungsmittel 38, 40 weisen jeweils eine identische Leitergeometrie auf. Unter einer identischen Leitergeometrie ist in diesem Zusammenhang eine identische Leiterquerschnittsfläche und eine identische Leiterquerschnittsform zu verstehen. Exemplarisch werden in FIG 3 Bonddrähte mit einer Leiterdicke von 500 µm verwendet. Eine Verbindung von Bondverbindungsmitteln 38, 40 mit identischer Leitergeometrie an den Steuerkontakt 6 und den Lastkontakt 8 wird durch das metallische Kontaktierungselement 22, welches mit dem Steuerkontakt 6 verbunden ist, ermöglicht. Durch die im Vergleich zur Steuerkontakt-Kontaktfläche 12 größere Kontaktierungselement-Kontaktfläche 24 wird eine Bondverbindung mit denselben Bondverbindungsmitteln 38, 40 ermöglicht, sodass die die Lastkontakt-Kontaktfläche 14 und die Kontaktierungselement-Kontaktfläche 24 in einem Prozesschritt mit dem Substrat 32 verbunden werden können. Unter einer Verbindung in einem Prozesschritt ist in diesem Zusammenhang zu verstehen, dass die Kontaktierung der Lastkontakt-Kontaktfläche 14 und der Kontaktierungselement-Kontaktfläche 24 mit Hilfe einer einzigen Maschine und/oder von derselben Spule erfolgt. Die weitere Ausgestaltung der Halbleiteranordnung 2 in FIG 3 entspricht der in FIG 2.

FIG 4 zeigt eine schematische Darstellung eines Stromrichters 42, welcher beispielhaft eine Halbleiteranordnung 4 umfasst.

Zusammenfassend betrifft die Erfindung eine Halbleiteranordnung 2 mit einem schaltbaren Halbleiterelement 4, welches zumindest ein Steuerkontakt 6 mit einer Steuerkontakt-Kontaktfläche 12 und zumindest einen Lastkontakt 8 mit einer Lastkontakt-Kontaktfläche 14, welche größer als die Steuerkontakt-Kontaktfläche 12 ist, aufweist, wobei die Steuerkontakt-Kontaktfläche 12 und die Lastkontakt-Kontaktfläche 14 bündig auf einer Halbleiteroberfläche 16 abschließend angeordnet sind. Um eine einfache und günstigere Kontaktierung zu ermöglichen, wird vorgeschlagen, dass ein metallisches Kontaktierungselement 22 flächig mit der Steuerkontakt-Kontaktfläche 12 des Steuerkontakts 6 verbunden ist, wobei das metallische Kontaktierungselement 22 eine auf einer der Steuerkontakt-Kontaktfläche 12 abgewandten Seite angeordnete Kontaktierungselement-Kontaktfläche 24 aufweist, welche größer als die Steuerkontakt-Kontaktfläche 12 ist, wobei das metallische Kontaktierungselement 22 die Lastkontakt-Kontaktfläche 14 des Lastkontakts 8 teilweise überlappt, wobei zwischen dem metallischen Kontaktierungselement 22 und der Lastkontakt-Kontaktfläche 14 des Lastkontakts 8 eine elektrisch isolierende Schicht 26 angeordnet ist.

## Patentansprüche

1. Halbleiteranordnung (2) mit einem schaltbaren Halbleiterelement (4),
welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist,
wobei die Steuerkontakt-Kontaktfläche (12) und die Lastkontakt-Kontaktfläche (14) bündig auf einer Halbleiteroberfläche (16) abschließend angeordnet sind,
wobei ein metallisches Kontaktierungselement (22) flächig mit der Steuerkontakt-Kontaktfläche (12) des Steuerkontakts (6) verbunden ist,
wobei das metallische Kontaktierungselement (22) eine auf einer der Steuerkontakt-Kontaktfläche (12) abgewandten Seite angeordnete Kontaktierungselement-Kontaktfläche (24) aufweist,
welche größer als die Steuerkontakt-Kontaktfläche (12) ist, wobei das metallische Kontaktierungselement (22) die Lastkontakt-Kontaktfläche (14) des Lastkontakts (8) teilweise überlappt,
wobei zwischen dem metallischen Kontaktierungselement (22) und der Lastkontakt-Kontaktfläche (14) des Lastkontakts (8) eine elektrisch isolierende Schicht (26) angeordnet ist.

2. Halbleiteranordnung (2) nach Anspruch 1,
wobei die Kontaktierungselement-Kontaktfläche (24) mindestens vier Mal, insbesondere mindestens acht Mal, so groß wie die Steuerkontakt-Kontaktfläche (12) ist.

3. Halbleiteranordnung (2) nach einem der Ansprüche 1 oder 2,
wobei das metallische Kontaktierungselement (22) stoffschlüssig mit Steuerkontakt-Kontaktfläche (12) verbunden ist.

4. Halbleiteranordnung (2) nach einem der vorherigen Ansprüche,
wobei das metallische Kontaktierungselement (22) zumindest teilweise mittels eines lithographischen, insbesondere photolithographischen, Verfahrens aufgebracht ist.

5. Halbleiteranordnung (2) nach einem der Ansprüche 1 bis 3,
wobei das metallische Kontaktierungselement (22) über eine Sinterverbindung (30) mit der Steuerkontakt-Kontaktfläche (12) verbunden ist.

6. Halbleiteranordnung (2) nach einem der vorherigen Ansprüche,
wobei die elektrisch isolierende Schicht (26) stoffschlüssig mit der Lastkontakt-Kontaktfläche (14) verbunden ist.

7. Halbleiteranordnung (2) nach Anspruch 6,
wobei das metallische Kontaktierungselement (22) flächig auf der elektrisch isolierenden Schicht (26) aufliegt.

8. Halbleiteranordnung (2) nach einem der vorherigen Ansprüche,
wobei die elektrisch isolierende Schicht (26) mittels eines lithographischen, insbesondere photolithographischen, Verfahrens auf die Lastkontakt-Kontaktfläche (14) aufgebracht ist.

9. Halbleiteranordnung (2) nach einem der Ansprüche 1 bis 5,
wobei die elektrisch isolierende Schicht (26) zumindest teilweise durch Oxidieren des metallische Kontaktierungselements (22) hergestellt ist.

10. Halbleiteranordnung (2) nach einem der vorherigen Ansprüche,
wobei die Lastkontakt-Kontaktfläche (14) über zumindest ein erstes Bondverbindungsmittel (38) und
die Kontaktierungselement-Kontaktfläche (24) über ein zweites Bondverbindungsmittel (40) mit einem Substrat (32) verbunden ist,
wobei eine Leitergeometrie des zumindest einen ersten Bondverbindungsmittels (38) mit einer Leitergeometrie des zweiten Bondverbindungsmittels (40) übereinstimmt.

11. Stromrichter (42) mit mindestens einer Halbleiteranordnung (2) nach einem der vorherigen Ansprüche.

12. Verfahren zur Herstellung einer Halbleiteranordnung (2) mit einem schaltbaren Halbleiterelement (4),
welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist,
wobei die Steuerkontakt-Kontaktfläche (12) und die Lastkontakt-Kontaktfläche (14) bündig auf einer Halbleiteroberfläche (16) abschließend angeordnet sind,
wobei ein metallisches Kontaktierungselement (22) mit einer Kontaktierungselement-Kontaktfläche (24), welche größer als die Steuerkontakt-Kontaktfläche (12) ist, bereitgestellt wird,
wobei das metallische Kontaktierungselement (22) auf einer der Kontaktierungselement-Kontaktfläche (24) abgewandten Seite derartig flächig mit der Steuerkontakt-Kontaktfläche (12) des Steuerkontakts (6) verbunden wird,
dass das metallische Kontaktierungselement (22) die Lastkontakt-Kontaktfläche (14) des Lastkontakts (8) teilweise überlappt,
wobei zwischen dem metallischen Kontaktierungselement (22) und der Lastkontakt-Kontaktfläche (14) des Lastkontakts (8) eine elektrisch isolierende Schicht (26) angeordnet wird.

13. Verfahren nach Anspruch 12,
wobei das metallische Kontaktierungselement (22) zumindest teilweise mittels eines lithographischen, insbesondere photolithographischen, Verfahrens aufgebracht wird.

14. Verfahren nach Anspruch 12,
wobei das metallische Kontaktierungselement (22) über eine Sinterverbindung (30) mit der Steuerkontakt-Kontaktfläche (12) verbunden wird.

15. Verfahren nach einem der Ansprüche 12 bis 14,
wobei die elektrisch isolierende Schicht (26) mittels eines lithographischen, insbesondere photolithographischen, Verfahrens auf die Lastkontakt-Kontaktfläche (14) aufgebracht wird.

16. Verfahren nach einem der Ansprüche 12 bis 14,
wobei die elektrisch isolierende Schicht (26) zumindest teilweise durch Oxidieren des metallische Kontaktierungselements (22) hergestellt wird.

17. Verfahren nach einem der Ansprüche 12 bis 16,
wobei die Lastkontakt-Kontaktfläche (14) und die Kontaktierungselement-Kontaktfläche (24) in einem Prozesschritt über Bondverbindungsmittel (38, 40) mit einem Substrat (32) verbunden werden.
